# EUROPEAN PATENT SPECIFICATION

(11) **EP 3 971 245 B1**
(45) Date of publication and mention of the grant of the patent: **18.02.2026**
(21) Application number: 20806133.3
(22) Date of filing: 07.05.2020
(51) Int. Cl.: C08L 101/00, C01G 49/00, H01F 1/34, H01F 1/37, C08K 3/22, H01Q 17/00, H05K 9/00, C08L 23/16

(54) **RADIO WAVE ABSORBER**
FUNKWELLENABSORBER
ABSORBEUR D'ONDES RADIO

(30) Priority: 14.05.2019 JP 2019091319
(43) Date of publication of application: 23.03.2022
(73) Proprietor: FUJIFILM Corporation, Tokyo 106-8620 (JP)
(72) Inventor: SHIRATA, Masashi, Minamiashigara-shi, Kanagawa 250-0193 (JP); HASHIMOTO, Hirokazu, Minamiashigara-shi, Kanagawa 250-0193 (JP)
(74) Representative: Klunker IP Patentanwälte PartG mbB
(86) International application number: PCT/JP2020/018479
(87) International publication number: WO 2020/230680

(56) References cited:
- WO-A1-2016/117648
- JP-A- 2007 250 823
- JP-A- 2010 260 766
- JP-A- 2018 056 492
- JP-A- H11 354 972

## Description

### BACKGROUND OF THE INVENTION

### Field of the Invention

The present invention relates to a radio wave absorber.

### Description of the Related Art

In recent years, the use pattern of radio waves are diversified to electronic toll collection system (ETC), advanced cruise-assist highway systems (AHS), satellite broadcasting, automatic driving control system, next-generation communication (5 generation (G), 6G), and the like. Under such circumstances, in recent years, a radio wave absorber has attracted attention as a member for suppressing the occurrence of malfunctions, failures, or the like of electronic devices due to radio wave interference (see, for example, JP2018-154541A and JP2018-56492A).

PTL3 relates to a magnetoplumbite-type hexagonal ferrite which exhibits a property in which, when it is used in a radiowave absorber, the matching frequency is substantially insensitive to the variation of the thickness of the radiowave absorber. The hexagonal magnetoplumbite-type ferrite is represented by the compositional formula: AFe₍₁₂₋ₓ₎(B1_{0.5}B2_{0.5})ₓO₁₉, wherein A is Ba and/or Sr; B1 is Ti and/or Zr; and B2 is a divalent metallic element, provided that B2 includes two or more selected from among Co, Mn, Cu, Mg, Zn, and Ni.

PTL4 describes a ferrite powder having a residual magnetization and a coercive force larger than those of spherical hard ferrite particle, and magnetic permeability µ" is maximum in a specific frequency range, a manufacturing method thereof, a resin compound containing the ferrite powder, and a molded product made from the resin compound. Provided is a hexagonal plate shaped ferrite powder containing 7.8 to 9 wt% of Sr, 61 to 65 wt% of Fe, and 0.1 to 0.65 wt% of Mg.

PTL5 relates to a wave absorber for absorbing electric waves around 76 GHz, which exhibits practical performance with a sheet thickness of 0.5 mm or less through the use of a magnetoplumbite hexagonal ferrite. In the powder of the magnetoplumbite hexagonal ferrite expressed by a composition formula of AFe₁₂₋ₓAlₓO₁₉, A refers to one or more of Sr, Ba, Ca and Pb, and x is 1.0 to 2.2. The wave absorber with a thickness of 0.5 mm or less is structured using a magnetic powder for use of the wave absorber with a peak grain diameter of a laser diffraction scattering grain size distribution of 10 µm or larger.

PTL6 relates to powders of magnetoplumbite type hexagonal ferrite, which are prepared by mixing BaFe₈(Ti_{0.5}Mn_{0.5})₄O₁₉ and Z type hexagonal ferrite Ba₃Co₂Fe₂₄O₄₁ and epoxy resin at a wt. ratio 35:35:30 to form a composite material, which is sheeted into a flat plate of 2.7 mm thick and backed with a conductor (metal) plate to form a radio wave absorber and an absorbing power of 20 dB or more at a frequency of 5-18 GHz in free space is obtained from its absorbing characteristic.

### Citation List

### Patent Literature

PTL1: JP2018-154541A
PTL2: JP2018-56492A
PTL3: JP 2010-260766 A
PTL4: WO 2016/117648 A1
PTL5: JP 2007-250823 A
PTL6: JP H11-354972 A

### SUMMARY OF THE INVENTION

As radio wave absorbers, as disclosed in JP2018-154541A and JP2018-56492A, those containing a magnetic powder as a radio wave absorbing material are known. As such a magnetic powder, JP2018-154541A proposes hexagonal ferrite.

In addition, examples of the radio wave absorber containing a magnetic powder include a radio wave absorber (see JP2018-154541A) consisting of a sintered product of a magnetic powder and a radio wave absorber (see JP2018-56492A) obtained by mixing a magnetic powder with a binder. From the viewpoint of workability into a desired shape, it is desirable to use a radio wave absorbing material in combination with a binder.

Accordingly, the inventors of the present invention examined a conventional radio wave absorber containing a powder of a hexagonal ferrite and a binder, and, as a result, it was revealed that the sufficient radio wave absorbability is not always exhibited. The present invention is defined in the appended claims.

One aspect of the present invention is to provide a radio wave absorber containing a powder of a hexagonal ferrite and a binder and capable of exhibiting excellent radio wave absorbability.

One aspect of the present invention relates to a radio wave absorber including a powder of a hexagonal ferrite and a binder, in which the radio wave absorber has a squareness ratio in a range of 0.40 to 0.60, wherein the hexagonale ferrite is a substitution-type magnetoplumbite-type hexagonal ferrite in which a part of iron atoms of the magnetoplumbite-type hexagonal ferrite is substituted with an aluminum atom.

In one aspect, the squareness ratio can be in a range of 0.45 to 0.55.

In one aspect, the hexagonal ferrite can have a composition represented by Formula 1.

Formula 1 AFE₍₁₂₋ₓ₎ALₓO₁₉

(In Formula 1, A represents at least one kind of atom selected from the group consisting of Sr, Ba, Ca, and Pb, and x satisfies 1.50 ≤ x ≤ 8.00.)

In one aspect, the atom represented by A in Formula 1 can include Sr.

In one aspect, the radio wave absorber can be a molded product obtained by molding a composition containing the powder of a hexagonal ferrite and the binder.

In one aspect, the radio wave absorber can be a plate-shaped molded product.

According to one aspect of the present invention, it is possible to provide a radio wave absorber containing a powder of a hexagonal ferrite and a binder and exhibiting excellent radio wave absorbability.

### DESCRIPTION OF THE PREFERRED EMBODIMENTS

One aspect of the present invention relates to a radio wave absorber including a powder of a hexagonal ferrite and a binder, in which the radio wave absorber has a squareness ratio in a range of 0.40 to 0.60.

Hereinafter, the radio wave absorber will be described in more detail.

In the present invention and the present specification, the "radio wave" means an electromagnetic wave having a frequency of 3 terahertz (THz) or less. The radio wave absorber has radio wave absorbability. The radio wave absorbability can be evaluated by, for example, the transmission attenuation amount described later, and it can be said that the higher the value of the transmission attenuation amount, the more excellent the radio wave absorbability.

In the present invention and the present specification, the "powder" means an aggregation of a plurality of particles. The "aggregation" is not limited to an aspect in which particles that constitute an aggregation are in direct contact with each other, and also includes an aspect in which a binder or the like is interposed between the particles.

### <Squareness ratio>

The squareness ratio of the radio wave absorber is in a range of 0.40 to 0.60. The squareness ratio is a value that can be an indicator of the presence state and the crystallinity of the radio wave absorbing material in the radio wave absorber. By the way, JP2018-56492A described above describes that in the radio wave absorbing layer containing a radio wave absorbing material and a binder, the easily magnetizable axis of the radio wave absorbing material should be aligned in the magnetic field in one in-plane direction of the radio wave absorbing sheet (see claim 1 of JP2018-56492A). On the other hand, in the radio wave absorber that exhibits a squareness ratio of 0.60 or less, it can be said that a plurality of particles constituting the powder of a hexagonal ferrite are randomly present since the easily magnetizable axes thereof are oriented in various directions. In addition, the powder of a hexagonal ferrite contained in the radio wave absorber that exhibits a squareness ratio of 0.40 or more can be said to have good crystallinity due to, for example, the little decrease in crystallinity of hexagonal ferrite in the powder processing process. As a result of diligent examinations by the inventors of the present invention, it has been revealed that the above facts lead to the improvement of the radio wave absorbability of the radio wave absorber containing a powder of a hexagonal ferrite and a binder. From the viewpoint of further improving the radio wave absorbability, the squareness ratio of the radio wave absorber is preferably 0.42 or more, more preferably 0.44 or more, still more preferably 0.45 or more, and even still more preferably 0.47 or more. From the same viewpoint as above, the squareness ratio of the radio wave absorber is preferably 0.58 or less, more preferably 0.56 or less, still more preferably 0.55 or less, and even still more preferably 0.53 or less. The squareness ratio of the radio wave absorber can be controlled by a method of preparing a powder of a hexagonal ferrite that is used for preparing the radio wave absorber. Details of this point will be described later.

In the present invention and the present specification, the squareness ratio of the radio wave absorber includes a squareness ratio measured in any direction (hereinafter, a "measurement direction A") randomly determined in the measurement sample, and a squareness ratio measured in the direction (hereinafter, a "measurement direction B") perpendicular to the measurement direction A. The measurement direction is a direction in which the magnetic field is applied at the time of measurement. The description that "the squareness ratio of the radio wave absorber is in a range of 0.40 to 0.60" means that both the squareness ratio measured in the measurement direction A and the squareness ratio measured in the measurement direction B are in a range of 0.40 to 0.60. For the squareness ratio measurement, the radio wave absorber itself to be measured is used as a measurement sample or cut out from the radio wave absorber to be measured, thereby being used as a measurement sample. The shape and the size of the measurement sample are not particularly limited as long as they can be measured by the measurement device. The squareness ratio is measured by the following method.

In an oscillating sample magnetometer, the intensity of magnetization of the measurement sample is measured with respect to an applied magnetic field under the conditions of a maximum applied magnetic field of 50 kOe and a magnetic field sweep rate of 104 Oe/s (seconds) in an environment with an ambient temperature of 23°C. From the measurement result, a magnetic field (H) - magnetization (M) curve is obtained for the measurement sample. Based on the obtained magnetic field (H) - magnetization (M) curve, the saturation magnetization (σs) and the residual magnetization (σr) (unit: Am²/kg) are determined, and the squareness ratio (SQ) is calculated as "σr/σs". The units thereof are respectively 1 Am²/kg = 1 emu/g and 1 kOe = (10⁶/4π) A/m.

### <Powder of hexagonal ferrite>

In the present invention and the present specification, the "powder of a hexagonal ferrite" refers to a magnetic powder in which a hexagonal ferrite-type crystal structure is detected as the main phase by X-ray diffraction analysis. The main phase refers to a structure to which the highest intensity diffraction peak attributes in the X-ray diffraction spectrum obtained by X-ray diffraction analysis. For example, in a case where the highest intensity diffraction peak in the X-ray diffraction spectrum obtained by X-ray diffraction analysis attributes to the hexagonal ferrite-type crystal structure, it is determined that the hexagonal ferrite-type crystal structure is detected as the main phase. In a case where only a single structure is detected by X-ray diffraction analysis, this detected structure is used as the main phase. The hexagonal ferrite-type crystal structure contains at least an iron atom, a divalent metal atom, and an oxygen atom as constituent atoms. The divalent metal atom is a metal atom that is capable of being a divalent cation, as an ion, and examples thereof include an alkaline earth metal atom such as a strontium atom, a barium atom, or a calcium atom, and a lead atom. In the present invention and the present specification, the hexagonal strontium ferrite powder means one in which the main divalent metal atom contained in this powder is a strontium atom, and the hexagonal barium ferrite powder means one in which the main divalent metal atom contained in this powder is a barium atom. The main divalent metal atom means a divalent metal atom that occupies the largest amount among the divalent metal atoms contained in this powder based on the % by atom. However, rare earth atoms are not included in the above divalent metal atoms. The "rare earth atom" in the present invention and the present specification is selected from the group consisting of a scandium atom (Sc), a yttrium atom (Y), and a lanthanoid atom. The lanthanoid atom is selected from the group consisting of a lanthanum atom (La), a cerium atom (Ce), a praseodymium atom (Pr), a neodymium atom (Nd), a promethium atom (Pm), a samarium atom (Sm), a europium atom (Eu), a gadolinium atom (Gd), a terbium atom (Tb), a dysprosium atom (Dy), a holmium atom (Ho), an erbium atom (Er), a thulium atom (Tm), a ytterbium atom (Yb), and a lutetium atom (Lu).

The fact that the magnetic powder contained in the radio wave absorber is a powder of a hexagonal ferrite can be checked by extracting the magnetic powder from the radio wave absorber by a known method and carrying out X-ray diffraction analysis on the extracted magnetic powder. Alternatively, it can be checked by, for example, the following method. A part or all of the radio wave absorber is finely chopped, immersed in a solvent (for example, acetone) for 1 or 2 days, and then dried. The dried radio wave absorber is further ground finely and subjected to X-ray diffraction analysis.

By the way, along with the rapid development of the information and communication technology in recent years, there is an increasing need for a radio wave absorber that exhibits excellent radio wave absorbability in a higher frequency band. From the viewpoint of improving the radio wave absorbability in the high frequency band, a substitution-type magnetoplumbite-type hexagonal ferrite in which a part of iron atoms of the magnetoplumbite-type hexagonal ferrite is substituted with an aluminum atom is used. As one aspect of such hexagonal ferrite, hexagonal ferrite having a composition represented by Formula 1 can be mentioned.

Formula 1 AFE₍₁₂₋ₓ₎AlₓO₁₉

In Formula 1, A represents at least one kind of atom (hereinafter, also referred to as an "A atom") selected from the group consisting of Sr, Ba, Ca, and Pb, it may be only one kind of atom, it may contain two or more kinds of atoms in any ratio, and, from the viewpoint of improving the uniformity of the composition between particles that constitute the powder, it is preferably only one kind of atom.

From the viewpoint of radio wave absorbability in the high frequency band, A in Formula 1 is preferably at least one kind of atom selected from the group consisting of Sr, Ba, and Ca, and more preferably Sr.

In Formula 1, x satisfies 1.50 ≤ x ≤ 8.00. From the viewpoint of radio wave absorbability in the high frequency band, x is 1.50 or more, more preferably more than 1.50, still more preferably 2.00 or more, and even still more preferably more than 2.00. In addition, from the viewpoint of magnetic properties, x is 8.00 or less, preferably less than 8.00, more preferably 6.00 or less, and still more preferably less than 6.00.

Specific examples of the magnetoplumbite-type hexagonal ferrite represented by Formula 1 include SrFe_{(9.58)}Al_{(2.42)}O₁₉, SrFe_{(9.37)}Al_{(2.63)}O₁₉, SrFe_{(9.27)}Al_{(2.73)}O₁₉, SrFe_{(9.85)}Al_{(2.15)}O₁₉, SrFe_{(10.00)}Al_{(2.00)}O₁₉, SrFe_{(9.74)}Al_{(2.26)}O₁₉, SrFe_{(10.44)}Al_{(1.56)}O₁₉, SrFe_{(9.79)}Al_{(2.21)}O₁₉, SrFe_{(9.33)}Al_{(2.67)}O₁₉, SrFe_{(7.88)}Al_{(4.12)}O₁₉, SrFe_{(7.04)}Al_{(4.96)}O₁₉, SrFe_{(7.37)}Al_{(4.63)}O₁₉, SrFe_{(6.25)}Al_{(5.75)}O₁₉, SrFe_{(7.71)}Al_{(4.29)}O₁₉, Sr_{(0.80)}Ba_{(0.10)}Ca_{(0.10)}Fe_{(9.83)}Al_{(2.17)}O₁₉, BaFe_{(9.50)}Al_{(2.50)}O₁₉, CaFe_{(10.00)}Al_{(2.00)}O₁₉, and PbFe_{(9.00)}Al_{(3.00)}O₁₉. The composition of hexagonal ferrite can be checked by high frequency inductively coupled plasma emission spectroscopy. Specific examples of the checking method include a method described in Examples described later. Alternatively, after exposing a cross section by cutting the radio wave absorber or the like, the exposed cross section is subjected to, for example, energy dispersive X-ray analysis, whereby the composition of the magnetic powder contained in the radio wave absorber can be checked.

In one aspect, in the powder of a hexagonal ferrite contained in the radio wave absorber, the crystal phase can be a single crystal phase, and a plurality of crystal phases can be included. It is preferable that the crystal phase is a single phase, and it is more preferable that the powder of a hexagonal ferrite is a powder of a magnetoplumbite-type hexagonal ferrite in which the crystal phase is a single phase.

The case where the "crystal phase is a single phase" refers to a case where only one kind of diffraction pattern showing any crystal structure is observed in the X-ray diffraction analysis. The X-ray diffraction analysis can be carried out, for example, by the method described in Examples described later. In a case where a plurality of crystal phases are included, two or more kinds of diffraction patterns showing any crystal structure are observed in the X-ray diffraction analysis. Regarding the attribution of the diffraction pattern, for example, a database of the International Centre for Diffraction Data (ICDD, registered trade name) can be referenced. For example, regarding the diffraction pattern of the magnetoplumbite-type hexagonal ferrite containing Sr, "00-033-1340" of the International Centre for Diffraction Data (ICDD) can be referred to. However, in a case where a part of iron atoms are substituted with a substituent atom such as an aluminum atom, the peak position shifts from the peak position observed in a case where the substituent atom is not included.

In addition, regarding the magnetic properties of the powder of a hexagonal ferrite contained in the radio wave absorber, the magnetic field strength Hα which is 90% of the magnetization quantity obtained in a case where an external magnetic field of 50 kOe is applied is preferably 19 kOe or more and 28 kOe or less from the viewpoint of improving the radio wave absorbability in the high frequency band. The magnetic field strength Hα is more preferably 20 kOe or more, still more preferably 21 kOe or more, and even still more preferably 22 kOe or more, from the viewpoint of further improving the radio wave absorbability in the high frequency band. In addition, from the same viewpoint as above, the magnetic field strength Hα is more preferably 27 kOe or less, still more preferably 26 kOe or less, and even still more preferably 25 kOe or less. The magnetic field strength Hα of the powder of a hexagonal ferrite can be adjusted by the composition of the hexagonal ferrite, the producing method, and the like.

The magnetic field strength Hα is a value obtained by the following method.

Using an oscillating sample magnetometer, the intensity of magnetization of the powder is measured with respect to an applied magnetic field under the conditions of a maximum applied magnetic field of 50 kOe and a magnetic field sweep rate of 25 Oe/s (where "s" indicates "second") in an environment with an ambient temperature of 23°C. Then, based on the measurement result, a magnetic field (H) - magnetization (M) curve of the powder is obtained. Based on the obtained magnetic field (H) - magnetization (M) curve, a magnetic field strength which corresponds to 90% of a magnetization quantity at an applied magnetic field of 50 kOe is obtained, which is denoted by the magnetic field strength Hα.

The shape of the particle that constitutes the powder of a hexagonal ferrite is not particularly limited, and examples thereof include a spherical shape, a rod shape, a needle shape, a plate shape, and an irregular shape. Examples of the shape of the particle that constitutes the powder of a magnetoplumbite-type hexagonal ferrite include a plate shape and an irregular shape.

The radio wave absorber contains a powder of a hexagonal ferrite and a binder. The filling rate of the powder of a hexagonal ferrite in the radio wave absorber is not particularly limited. For example, the volume filling rate can be 35% by volume or less and can be also in a range of 15 to 35% by volume. Further, in one aspect, the filling rate of the powder of a hexagonal ferrite in the radio wave absorber can be 35% by volume or more as the volume filling rate. In this case, the volume filling rate can be, for example, in a range of 35% to 60% by volume and is preferably in a range of 35% to 50% by volume. The volume filling rate means a volume-based content with respect to 100% by volume of the total volume of the radio wave absorber.

### (Method of producing powder of hexagonal ferrite)

Examples of the method of producing a powder of a hexagonal ferrite include a solid phase method and a liquid phase method. The solid phase method is a method of producing a powder of a hexagonal ferrite by sintering a mixture obtained by mixing a plurality of solid raw materials in a dry-type manner. On the other hand, the liquid phase method includes a step of using a solution. Hereinafter, one aspect of the method of producing a powder of a hexagonal ferrite by the liquid phase method will be described. However, the method of producing a powder of a hexagonal ferrite contained in the radio wave absorber is not limited to the following aspect.

One aspect of the liquid phase method can include;
a step 1 of obtaining a precipitate from a solution containing an iron atom, at least one kind of atom selected from the group consisting of Sr, Ba, Ca, and Pb, and, as necessary, one or more substituent atoms that substitute an iron atom,
a step 2 of sintering the precipitate obtained in the step 1 to obtain a sintered product, and
a step 3 of pulverizing the sintered product obtained in the step 2.

Hereinafter, each step will be described in detail.

### Step 1

In the step 1, a hexagonal ferrite precursor can be obtained as a precipitate. For example, in order to obtain a powder of a hexagonal ferrite containing an aluminum atom as a substituent atom that substitutes a part of iron atoms, an iron atom, an A atom, and an aluminum atom can be mixed in a solution. In this case, it is presumed that the precipitate obtained in the step 1 is iron hydroxide, aluminum hydroxide, a composite hydroxide of an iron atom, an aluminum atom, and an A atom, and the like.

The solution for obtaining the precipitate in the step 1 is preferably a solution containing at least water and is more preferably an aqueous solution. For example, a precipitate can be generated by mixing an aqueous solution containing various atoms (hereinafter, also referred to as a "raw material aqueous solution") with an alkaline aqueous solution. In addition, the step 1 can include a step of carrying out the solid-liquid separation of the precipitate.

The raw material aqueous solution can be, for example, an aqueous solution containing an Fe salt, an Al salt, and a salt of an A atom. These salts can be, for example, water-soluble inorganic acid salts such as nitrates, sulfates, and chlorides.

Specific examples of the Fe salt include iron (III) chloride hexahydrate [FeCl₃·6H₂O] and iron (III) nitrate nonahydrate [Fe (NO₃)₃·9H₂O].

Specific examples of the Al salts include aluminum chloride hexahydrate [AlCl₃·6H₂O] and aluminum nitrate nonahydrate [Al (NO₃)₃·9H₂O].

The salt of the A atom can be one or more kinds of salts selected from the group consisting of a Sr salt, a Ba salt, a Ca salt, and a Pb salt.

Specific examples of the Sr salt include strontium chloride hexahydrate [SrCl₂·6H₂O], strontium nitrate [Sr(NO₃)₂], and strontium acetate 0.5 hydrate [Sr(CH₃COO)₂·0.5H₂O].

Specific examples of the Ba salt include barium chloride dihydrate [BaCl₂·2H₂O], barium nitrate [Ba(NO₃)_{2]}, and barium acetate [(CH₃COO)₂Ba].

Specific examples of the Ca salt include calcium chloride dihydrate [CaCl₂·2H₂O], calcium nitrate tetrahydrate [Ca(NO₃)₂·4H₂O], and calcium acetate monohydrate [(CH₃COO)₂Ca·H₂O].

Specific examples of the Pb salt include lead (II) chloride [PbCl₂] and lead (II) nitrate [Pb(NO₃)₂].

However, the above is an example, and other salts can be also used. The mixing ratio between various salts for preparing the raw material aqueous solution may be determined depending on the desired hexagonal ferrite composition.

Examples of the alkaline aqueous solution include a sodium hydroxide aqueous solution and a potassium hydroxide aqueous solution. The concentration of the alkaline aqueous solution can be, for example, 0.1 mol/L to 10 mol/L. However, the kind and the concentration of the alkaline aqueous solution are not limited to the above examples as long as the precipitate can be produced.

The raw material aqueous solution and the alkaline aqueous solution may be simply mixed. The whole amount of the raw material aqueous solution and the whole amount of the alkaline aqueous solution may be mixed at one time, or the raw material aqueous solution and the alkaline aqueous solution may be gradually mixed. Alternatively, the mixing may be carried out by mixing while gradually adding one of the raw material aqueous solution and the alkaline aqueous solution to the other. The method of mixing the raw material aqueous solution with the alkaline aqueous solution is not particularly limited, and examples thereof include a method of mixing with stirring. A stirring unit is not particularly limited either, and a general stirring unit can be used. The stirring time may be set to a time during which a precipitate can be formed, and it can be appropriately set depending on the composition of the raw material aqueous solution, the kind of the stirring unit to be used, and the like.

The temperature (the solution temperature) at which the raw material aqueous solution is mixed with the alkaline aqueous solution is, for example, preferably 100°C or lower from the viewpoint of preventing explosive boil, and more preferably 95°C or lower and still more preferably 15°C or higher and 92°C or lower from the viewpoint of causing the precipitation reaction to proceed well. As a unit for adjusting the temperature, a general heating device, cooling device, or the like can be used. The pH of the aqueous solution obtained by mixing the raw material aqueous solution with the alkaline aqueous solution, at a temperature of 25°C, is, for example, preferably in a range of 5 to 13 and more preferably in a range of 6 to 12 from the viewpoint that a precipitate is more easily obtained.

In a case where the obtained precipitate is subjected to solid-liquid separation after the precipitate is formed, the method of thereof is not particularly limited, and examples thereof include decantation, centrifugation, and filtration (suction filtration, pressure filtration, or the like). For example, in a case where the solid-liquid separation is carried out by centrifugation, the conditions for centrifugation are not particularly limited, and for example, centrifugation can be carried out for 3 to 30 minutes at a rotation speed of 2,000 revolutions per minute (rpm) or more. Further, the centrifugation may be carried out a plurality of times.

### Step 2

The step 2 is a step of sintering the precipitate obtained in the step 1.

In the step 2, the precursor of hexagonal ferrite can be converted to hexagonal ferrite by sintering the precipitate obtained in the step 1. The sintering can be carried out using a heating device. The heating device is not particularly limited, and a known heating device such as an electric furnace, a sintering device manufactured according to a production line, or the like can be used. The sintering can be carried out, for example, in an ambient air atmosphere. The sintering temperature and the sintering time may be set within a range in which the precursor of hexagonal ferrite can be converted to hexagonal ferrite. The sintering temperature is, for example, preferably 900°C or higher, more preferably in a range of 900°C to 1,400°C, and still more preferably in a range of 1,000°C to 1,300°C. The sintering time is, for example, preferably in a range of 1 hour to 10 hours and more preferably in a range of 2 hours to 6 hours. In addition, the precipitate obtained in the step 1 can be dried before sintering. The drying unit is not particularly limited, and examples thereof include a dryer such as an oven. The drying temperature is, for example, preferably in a range of 50°C to 200°C and more preferably in a range of 70°C to 150°C. The drying time is, for example, preferably in a range of 2 hours to 50 hours and more preferably in a range of 5 hours to 30 hours. The above sintering temperature and drying temperature can be the internal ambient temperature of the device for sintering or drying.

### Step 3

The sintered product obtained in the above step 2 can be an aggregated sintered product or a powder-shaped sintered product, in which the precursor of hexagonal ferrite is converted to show the crystal structure of hexagonal ferrite. The step 3 is a step of pulverizing the sintered product. The pulverization can be carried out with a known pulverizing unit such as a mortar and pestle or a pulverizer (a cutter mill, a ball mill, a bead mill, a roller mill, a jet mill, a hammer mill, an attritor, or the like). For example, in the case of pulverizing using a medium, a particle size of the medium (a so-called medium diameter) is, for example, preferably in a range of 0.1 mm to 5.0 mm and more preferably in a range of 0.5 mm to 3.0 mm. The "medium diameter" in a case of a spherical medium means an arithmetic mean of diameters of a plurality of randomly selected media (for example, beads). In a case of a non-spherical medium (for example, a non-spherical bead), it means an arithmetic mean of equivalent circle diameters of a plurality of randomly selected media, which is determined from an observation image obtained from a transmission electron microscope (TEM) or a scanning electron microscope (SEM). Examples of the medium material include glass, alumina, steel, zirconia, and ceramics. In a case of pulverizing with a cutter mill, the pulverizing conditions can be determined depending on the amount of the sintered product to be pulverized, the scale of the cutter mill to be used, and the like. For example, in one aspect, the rotation speed of the cutter mill can be about 5,000 to 25,000 rpm.

The squareness ratio of the radio wave absorber can be controlled by, for example, the pulverizing time in the step 3. As the pulverizing time becomes long, the size of the particle that constitutes the powder tends to be small. For example, in the process of molding the radio wave absorber as a molded product, as the size of the particle that constitutes the powder becomes small, the easily magnetizable axes of the plurality of particles that constitute the powder of a hexagonal ferrite tend to be easily oriented in a certain direction, and the aligning properties tend to be enhanced, and the value of the squareness ratio tends to increase, and as the pulverizing time becomes long, the crystallinity of hexagonal ferrite tends to easily decrease. In a case where the crystallinity is low, the value of the squareness ratio of the radio wave absorber tends to be small. As a result, it is preferable to determine the pulverizing time in consideration of these points. The pulverizing time may be set depending on the kind of the pulverizing unit to be used and the like. In one aspect, the pulverizing time can be, for example, about 1 minute to 2 hours. It is also preferable to carry out the step 3 on the powder of a hexagonal ferrite obtained as a sintered product by the solid phase method.

### <Binder>

The radio wave absorber contains a powder of a hexagonal ferrite and a binder. The binder can be, for example, a resin, and examples of the resin include a thermoplastic resin and a thermosetting resin.

Examples of the thermoplastic resin include an acrylic resin, polyacetal, polyamide, polyethylene, polypropylene, polyethylene terephthalate, polybutylene terephthalate, polycarbonate, polystyrene, polyphenylene sulfide, polyvinyl chloride, an acrylonitrile butadiene styrene (ABS) resin obtained by copolymerization of acrylonitrile, butadiene, and styrene; and an acrylonitrile styrene (AS) resin obtained by copolymerization of acrylonitrile and styrene.

Examples of the thermosetting resin include a phenol resin, an epoxy resin, a melamine resin, a urea resin, an unsaturated polyester, a diallyl phthalate resin, a urethane resin, and a silicon resin.

The binder can also be rubber. From viewpoints that the mixability with the powder of a hexagonal ferrite is good and the radio wave absorber having more excellent durability, weather fastness, and impact resistance can be produced, examples of the rubber include butadiene rubber, isoprene rubber, chloroprene rubber, halogenated butyl rubber, fluororubber, urethane rubber, acrylic rubber (abbreviation: ACM) obtained by copolymerization of an acrylic acid ester (for example, ethyl acrylate, butyl acrylate, or 2-ethylhexyl acrylate) and another monomer, ethylene-propylene rubber obtained by coordination polymerization of ethylene and propylene using a Ziegler catalyst, butyl rubber (abbreviation: IIR) obtained by copolymerization of isobutylene and isoprene, styrene butadiene rubber (abbreviation: SBR) obtained by copolymerization of butadiene and styrene, acrylonitrile butadiene rubber (abbreviation: NBR) obtained by copolymerization of acrylonitrile and butadiene, and silicone rubber.

In a case where the radio wave absorber of the present disclosure contains rubber as the binder, it may contain various additives such as a vulcanizing agent, a vulcanization aid, a softener, and a plasticizer, in addition to the rubber. Examples of the vulcanizing agent include sulfur, an organic sulfur compound, and a metal oxide.

Examples of the binder include a thermoplastic elastomer (TPE). Examples of the thermoplastic elastomer include an olefin-based thermoplastic elastomer (a thermoplastic olefinic elastomer (TPO)), a styrene-based thermoplastic elastomer (a thermoplastic styrenic elastomer (TPS)), an amide-based thermoplastic elastomer (a thermoplastic polyamide elastomer (TPA), and a polyester-based thermoplastic elastomer (a thermoplastic copolyester (TPC)).

The radio wave absorber may include only one kind of binder and may include two or more kinds thereof. The filling rate of the binder in the radio wave absorber is not particularly limited; however, the volume filling rate thereof is, for example, preferably 65% by volume or more, more preferably 65% by volume or more and 92% by volume or less, and still more preferably 65% by volume or more and 85% by volume or less. In a case where the radio wave absorber contains two or more kinds of binders, the filling rate means the total filling rate of the two or more kinds of binders. This point also identically applies to the filling rates of other components.

### <Additive>

The radio wave absorber contains a powder of a hexagonal ferrite and a binder, and may optionally contain one or more additives. Examples of the additive include a dispersing agent, a dispersing aid, a fungicide, an antistatic agent, and an antioxidant. One component of the additive may carry out two or more functions. The radio wave absorber can contain, as the additive, a commercially available product or a product produced by a known method at any filling rate.

### <Method of producing radio wave absorber>

The method of producing the radio wave absorber of the present disclosure is not particularly limited. For example, it can be produced by a well known method using a powder of a hexagonal ferrite, a binder, and, as necessary, a solvent, other additives, and the like. For example, the radio wave absorber can be a molded product obtained by molding a composition (hereinafter, also referred to as a "composition for forming a radio wave absorber") containing powder of a hexagonal ferrite and a binder. The composition for forming a radio wave absorber can be prepared as a kneaded material by kneading, while heating, a mixture of a powder of a hexagonal ferrite, a binder, and, as necessary, a solvent, an additive, and the like. The kneaded material can be obtained, for example, as a pellet. The kneaded material is molded into a desired shape by a known molding method such as extrusion molding, press molding, injection molding, or in-mold forming, whereby a radio wave absorber (a molded product) can be obtained. The shape of the radio wave absorber is not particularly limited and may be any shape such as a plate shape or a linear shape. The "plate shape" includes a sheet shape and a film shape. The plate-shaped radio wave absorber can also be called a radio wave absorbing plate, a radio wave absorbing sheet, a radio wave absorbing film, or the like. The radio wave absorber may be a radio wave absorber having a single composition (for example, a single-layer radio wave absorbing plate) or a combination of two or more parts having different compositions (for example, a laminate). Further, the radio wave absorber may have a planar shape, may have a three-dimensional shape, or may be a combination of a portion having a planar shape and a portion having a three-dimensional shape. Examples of the planar shape include a sheet shape and a film shape. Examples of the three-dimensional shape include a tubular shape (a cylindrical shape, rectangular tubular shape, or the like), a horn shape, and a box shape (for example, at least one of the surfaces thereof is open).

For example, in a case of a plate-shaped radio wave absorber, the thickness thereof is preferably 20 mm or less, more preferably 10 mm or less, and still more preferably 5 mm or less. From the viewpoint of mechanical properties, the thickness of the plate-shaped radio wave absorber is preferably 1 mm or more and more preferably 2 mm or more. In a case where the plate-shaped radio wave absorber is a laminate, the thickness means the total thickness of the radio wave absorber constituting the laminate.

The composition for forming a radio wave absorber may contain or may not contain a solvent. In a case where the composition for forming a radio wave absorber contains a solvent, the solvent is not particularly limited, and examples thereof include water, an organic solvent, and a mixed solvent of water and an organic solvent.

Examples of the organic solvent include alcohols such as methanol, ethanol, n-propanol, i-propanol, and methoxypropanol, ketones such as acetone, methyl ethyl ketone, and cyclohexanone, tetrahydrofuran, acetonitrile, ethyl acetate, and toluene. Among these, the solvent is preferably ketones and more preferably cyclohexanone from the viewpoint of drying rate. In a case where the composition for forming a radio wave absorber contains a solvent, the content of the solvent in the composition is not particularly limited and may be determined depending on the method of producing a radio wave absorber.

The composition for forming a radio wave absorber can be prepared by mixing the above components. The mixing method is not particularly limited, and examples thereof include a method of mixing by stirring. As the stirring unit, a known stirring device can be used. Examples of the stirring device include mixers such as a paddle mixer and an impeller mixer. The stirring time may be set depending on the kind of the stirring device, the composition of a composition for forming a radio wave absorber, and the like.

Examples of one aspect of the method of producing a radio wave absorber include a method of molding a radio wave absorbing composition into a desired shape by a known molding method as exemplified above.

In addition, examples of another aspect of the method of producing a radio wave absorber include a method of applying a composition for forming a radio wave absorber onto a support and producing the radio wave absorber as a radio wave absorbing layer. The support that is used here may be removed before the radio wave absorber is incorporated into an article to which the radio wave absorbability should be imparted or may be incorporated into the article together with the radio wave absorber without being removed.

The support is not particularly limited, and a well known support can be used. Examples of the support include a metal plate (a plate of metal such as aluminum, zinc, or copper), a glass plate, a plastic sheet [a sheet of polyester (polyethylene terephthalate, polyethylene naphthalate, or polybutylene terephthalate), polyethylene (linear low-density polyethylene, low-density polyethylene, or high-density polyethylene), polypropylene, polystyrene, polycarbonate, polyimide, polyamide, polyamide imide, polysulfone, polyvinyl chloride, polyacrylonitrile, polyphenylene sulfide, polyether imide, polyether sulfone, polyvinyl acetal, or an acrylic resin], a plastic sheet on which the metal exemplified in the metal plate described above is laminated or vapor-deposited. The plastic sheet is preferably biaxially stretched. The shape, structure, size, and the like of the support can be appropriately selected. Examples of the shape of the support include a plate shape. The structure of the support may be a monolayer structure or a laminated structure of two or more layers. The size of the support can be appropriately selected depending on the size of the radio wave absorber and the like. The thickness of the support is generally approximately 0.01 mm to 10 mm, for example, preferably 0.02 mm to 3 mm and more preferably 0.05 mm to 1 mm, from the viewpoint of handleability.

The method of applying a composition for forming a radio wave absorber on a support is not particularly limited, and examples thereof include methods using a die coater, a knife coater, an applicator, and the like. The method of drying the coating film formed by applying a composition for forming a radio wave absorber is not particularly limited, and examples thereof include a method using a known heating device such as an oven. The drying temperature and the drying time are not particularly limited. For example, the drying temperature can be in a range of 70°C to 90°C, and the drying temperature can be in a range of 1 hour to 3 hours.

The radio wave absorber according to the one aspect of the present invention described above has radio wave absorbability. The frequency of the electromagnetic wave that exhibits radio wave absorbability is a frequency of the electromagnetic wave, which is defined as the radio wave, that is, 3 THz or less, and it can be, for example, a frequency of 3 gigahertz (GHz) to 300 GHz. From the viewpoint of usefulness in the radio wave absorption use application, the radio wave absorber preferably exhibits radio wave absorbability with respect to electromagnetic waves having an absorption peak in a frequency band of 60 GHz to 90 GHz and more preferably exhibits radio wave absorbability with respect to electromagnetic waves having an absorption peak in a frequency band of 75 GHz to 85 GHz. In one aspect, the radio wave absorber can have a transmission attenuation amount of 8.0 dB or more with respect to at least a part of frequencies in the frequency band of 3 GHz to 300 GHz and a transmission attenuation amount of 8.0 dB or more with respect to electromagnetic waves in the frequency band of 60 GHz to 90 GHz, where the transmission attenuation amount is measured by a method described in Examples which will be described later. Since it is preferable that the transmission attenuation amount is large from the viewpoint of usefulness in the radio wave absorption use application, the upper limit thereof is not particularly limited. As an example, the transmission attenuation amount can be, for example, 30.0 dB or less.

The radio wave absorber can be incorporated into various articles to which radio wave absorbability is desired to be imparted. For example, the plate-shaped radio wave absorber can be incorporated into an article in any form as it is or by being bent at any portion. In addition, it can be adjusted to a desired shape by injection molding or the like to be incorporated into an article.

### Examples

Hereinafter, the present invention will be described based on Examples. However, the present invention is not limited to aspects described in Examples. Unless otherwise specified, steps and evaluations described below were carried out in an environment of an ambient temperature of 23°C ± 1°C.

### [Production of magnetic powder (powder of hexagonal ferrite)]

### <Magnetic powder A>

As a magnetic powder, a powder of a magnetoplumbite-type hexagonal ferrite was prepared by the following method.

A total amount of a raw material aqueous solution prepared by dissolving 57.0 g of iron (III) chloride hexahydrate [FeCl₃·6H₂O], 27.8 g of strontium chloride hexahydrate [SrCl₂·6H₂O], and 10.7 g of aluminum chloride hexahydrate [AlCl₃·6H₂O] in 216.0 g of water, and a total amount of a solution prepared by adding 113.0 g of water to 181.3 g of a 5 mol/L sodium hydroxide aqueous solution were added to 400.0 g of water kept at a temperature of 35°C and stirred, respectively, at a flow rate of 10 mL/min and the same timing, to obtain a first solution.

Next, after allowing the solution temperature of the first solution to be 25°C, 45.3 g of an aqueous solution of sodium hydroxide of a concentration of 1 mol/L was added while maintaining this temperature to obtain a second solution. The pH of the second solution was 11.0. The pH was measured using a desktop pH meter (product name: F-71) manufactured by Horiba, Ltd.

Next, the second solution was stirred for 15 minutes, and a solution containing a precipitate which is a precursor of magnetoplumbite-type hexagonal ferrite (a precursor-containing solution) was obtained.

Next, the precursor-containing solution was subjected to the centrifugal separation treatment (rotation speed: 3,000 rpm, rotation time: 10 minutes] three times, and the obtained precipitate was collected.

Next, the collected precipitate was dried in an oven at an internal ambient temperature of 95°C for 12 hours to obtain a precursor powder.

Next, the precursor powder was put in a muffle furnace, and the temperature in the furnace was set to 1,100°C in an ambient air atmosphere, followed by sintering for 4 hours, thereby obtaining an aggregated sintered product.

Next, the obtained sintered product was pulverized for 90 seconds using a cutter mill (Wonder Crusher WC-3 manufactured by Osaka Chemical Co., Ltd.) as the pulverizer, with the variable speed dial of the pulverizer being set to "5" (rotation speed: about 10,000 to 15,000 rpm).

As a result, a magnetic powder A was obtained.

### <Magnetic powders B to H>

Each of magnetic powders B to H was prepared by the same method as the magnetic powder A, except that the pulverizing time of the sintered product was changed to the time shown in Table 1.

### [Checking of crystal structure]

The crystal structure of the magnetic material constituting each of the above magnetic powders was checked by X-ray diffraction analysis. As the measurement device, X'Pert Pro manufactured by PANalytical Co., Ltd., which is a powder X-ray diffractometer, was used. The measurement conditions are shown below.

### - Measurement conditions -

X-ray source: CuKα ray
[Wavelength: 1.54Å (0.154 nm), output: 40 mA, 45 kV]
Scan range: 20° < 2θ <70°
Scan interval: 0.05°
Scan speed: 0.75 °/min

As a result of the X-ray diffraction analysis, it was confirmed that all the above magnetic powders have a magnetoplumbite-type crystal structure and are a single-phase powder of a magnetoplumbite-type hexagonal ferrite that does not include a crystal structure other than the magnetoplumbite-type crystal structure.

### [Checking of composition]

The composition of the magnetic material constituting each of the above magnetic powders was checked by high frequency inductively coupled plasma emission spectroscopy. Specifically, the checking was carried out by the following method.

A beaker (a pressure-resistant container) containing 12 mg of the magnetic powder and 10 mL of an aqueous solution of hydrochloric acid of a concentration of 4 mol/L was held in an oven at a set temperature of 120°C for 12 hours to obtain a dissolution solution. 30 mL of pure water was added to the obtained dissolution solution, which is then filtered using a membrane filter having a filter pore diameter of 0.1 µm. Elemental analysis of the filtrate obtained as described above was carried out using a high frequency inductively coupled plasma emission spectrometer [ICPS-8100, manufactured by Shimadzu Corporation]. Based on the obtained elemental analysis results, a content of each atom with respect to 100% by atom of iron atoms was obtained. Then, based on the obtained content, the composition of the magnetic material was checked. As a result of the above, it was confirmed that all the above magnetic powders A to H are hexagonal ferrite (hexagonal strontium ferrite) powders having a composition of SrFe_{10.00}Al_{2.00}O₁₉.

### [Examples 1 to 4 and Comparative Examples 1 to 4]

Using a kneader (Labo Plastomill manufactured by Toyo Seiki Seisaku-sho, Ltd.), 100 g of the magnetic powder shown in Table 1 and 30 g of an olefin-based thermoplastic elastomer (TPO) [MILASTOMER (registered trade name) 7030NS manufactured by Mitsui Chemicals, Inc.) as a binder were kneaded for 10 minutes at a set temperature of 200°C and a rotation speed of 30 rpm to obtain a composition for forming a radio wave absorber (a pellet-shaped kneaded material).

By using a biaxial kneading extruder [KZW15TW manufactured by TECHNOVEL Corporation] and setting the screw temperature of 200°C, the obtained composition for forming a radio wave absorber was melted, and the melt was extruded from a die into a plate shape to obtain a radio wave absorber (thickness: 2 mm) as a plate-shaped molded product having a square plane, one side of which had a length of 100 mm.

### [Evaluation method]

### <Squareness ratio>

A plate-shaped measurement sample (thickness: 2 mm) having a square plane, one side of which had a length of 6 mm, was cut out from each of the above radio wave absorbers, and the squareness ratio was determined by the following method using an oscillating sample magnetometer. As the oscillating sample magnetometer, an oscillating sample magnetometer [model number: TM-TRVSM5050-SMSL type] manufactured by TAMAKAWA Co., Ltd. was used, and the saturation magnetization (σs) and the residual magnetization (σr) were determined under the measurement conditions described above. Each of the saturation magnetization (σs) and the residual magnetization (σr) was determined with respect to the measurement direction A and the measurement direction B, where the thickness direction was denoted by the measurement direction A and the in-plane direction perpendicular to the thickness direction was denoted by the measurement direction B. From the saturation magnetization (σs) and the residual magnetization (σr) obtained with respect to each of the measurement directions, the squareness ratio (SQ) was calculated with respect to each of the measurement directions as "σr/σs".

### <Measurement of transmission attenuation amount>

The transmission attenuation amount (unit: dB) of each of the above radio wave absorbers was measured by the following method.

As the measurement device, a vector network analyzer (product name: N5225B) manufactured by Keysight Technologies and a horn antenna (product name: RH12S23) manufactured by KEYCOM Corp were used to measure an S parameter with a free space method by setting an incidence angle to 0° and a sweep frequency to 60 GHz to 90 GHz, with one plane of each of the above radio wave absorbers being directed toward the incident side (that is, Port 1), and S21 of the S parameter at a frequency of 76.5 GHz was taken as the transmission attenuation amount.

The above results are shown in Table 1.

**[Table 1]**

| | Magnetic powder | Pulverizing time | Measurement direction A | | | Measurement direction B | | | Transmission attenuation amount |
|---|---|---|---|---|---|---|---|---|---|
| | | | σs | σr | SQ | σs | σr | SQ | |
| | | | Am²/kg | Am²/kg | - | Am²/kg | Am²/kg | - | dB |
| Example 1 | A | 90 seconds | 32 | 16 | 0.50 | 32 | 16 | 0.50 | 10.5 |
| Example 2 | B | 3 minutes | 32 | 17 | 0.53 | 30 | 14 | 0.47 | 10.4 |
| Example 3 | C | 30 minutes | 31 | 16 | 0.52 | 31 | 15 | 0.48 | 10.3 |
| Example 4 | D | 1 hour | 31 | 14 | 0.45 | 33 | 18 | 0.55 | 10.0 |
| Comparative Example 1 | E | 3 hours | 30 | 11 | 0.37 | 28 | 10 | 0.36 | 5.9 |
| Comparative Example 2 | F | 30 seconds | 32 | 20 | 0.63 | 32 | 13 | 0.41 | 7.3 |
| Comparative Example 3 | G | 10 seconds | 32 | 22 | 0.68 | 33 | 13 | 0.39 | 6.7 |
| Comparative Example 4 | H | 40 seconds | 32 | 13 | 0.41 | 32 | 21 | 0.66 | 7.0 |

From the results shown in Table 1, it can be confirmed that the radio wave absorbers of Examples have a high transmission attenuation amount value and have excellent radio wave absorbability as compared with the radio wave absorbers of Comparative Examples.

One aspect of the present invention is useful in various technical fields in which it is desired to suppress the occurrence of malfunctions, failures, or the like of electronic devices due to radio wave interference.

## Claims

1. A radio wave absorber comprising:
a powder of a hexagonal ferrite; and
a binder,
wherein the radio wave absorber has a squareness ratio in a range of 0.40 to 0.60, ,the squareness ratio being determined as disclosed in the description,
wherein the hexagonal ferrite is a substitution-type magnetoplumbite-type hexagonal ferrite in
which a part of iron atoms of the magnetoplumbite-type hexagonal ferrite is substituted with an aluminum atom.

2. The radio wave absorber according to claim 1,
wherein the radio wave absorber has a squareness ratio in a range of 0.45 to 0.55.

3. The radio wave absorber according to claim 1 or 2,
wherein the hexagonal ferrite has a composition represented by Formula 1,
Formula 1 AFE₍₁₂₋ₓ₎AlₓO₁₉
in Formula 1, A represents at least one kind of atom selected from the group consisting of Sr, Ba, Ca, and Pb, and x satisfies 1.50 ≤ x ≤ 8.00.

4. The radio wave absorber according to claim 3,
wherein an atom represented by A in Formula 1 includes Sr.

5. The radio wave absorber according to any one of claims 1 to 4,
wherein the radio wave absorber is a molded product obtained by molding a composition containing the powder of a hexagonal ferrite and the binder.

6. The radio wave absorber according to claim 5,
wherein the radio wave absorber is a plate-shaped molded product.

## Patentansprüche

1. Funkwellenabsorber, umfassend:
ein Pulver eines hexagonalen Ferrits; und
ein Bindemittel,
wobei der Funkwellenabsorber ein Rechteckverhältnis in einem Bereich von 0,40 bis 0,60 aufweist, wobei das Rechteckverhältnis wie in der Beschreibung offenbart bestimmt wird,
wobei der hexagonale Ferrit ein hexagonaler Ferrit von Magnetoplumbit-Typ des Substitutionstyps ist, bei dem ein Teil von Eisenatomen des hexagonalen Ferrits von Magnetoplumbit-Typ durch ein Aluminiumatom substituiert ist.

2. Funkwellenabsorber nach Anspruch 1,
wobei der Funkwellenabsorber ein Rechteckverhältnis in einem Bereich von 0,45 bis 0,55 aufweist.

3. Funkwellenabsorber nach Anspruch 1 oder 2,
wobei der hexagonale Ferrit eine Zusammensetzung, die durch Formel 1 dargestellt wird, aufweist,
Formel 1 AFE₍₁₂₋ₓ₎AlₓO₁₉
wobei in Formel 1 A mindestens eine Art von Atom, das aus der Gruppe, die aus Sr, Ba, Ca und Pb besteht, ausgewählt wird, darstellt und x 1,50 ≤ x ≤ 8,00 erfüllt.

4. Funkwellenabsorber nach Anspruch 3,
wobei ein Atom, das durch A in Formel 1 dargestellt ist, Sr enthält.

5. Funkwellenabsorber nach einem der Ansprüche 1 bis 4,
wobei der Funkwellenabsorber ein geformtes Produkt ist, das durch Formen einer Zusammensetzung, die das Pulver eines hexagonalen Ferrits und das Bindemittel enthält, erhalten wird.

6. Funkwellenabsorber nach Anspruch 5,
wobei der Funkwellenabsorber ein plattenförmig geformtes Produkt ist.

## Revendications

1. Absorbeur d'ondes radio comprenant :
une poudre d'une ferrite hexagonale ; et
un liant,
dans lequel l'absorbeur d'ondes radio présente un rapport de rectitude compris entre 0,40 et 0,60, le rapport de rectitude étant déterminé comme décrit dans la description, dans lequel la ferrite hexagonale est une ferrite hexagonale de type magnétoplumbite de type substitution dans laquelle une partie d'atomes de fer de la ferrite hexagonale de type magnétoplumbite est substituée par un atome d'aluminium.

2. Absorbeur d'ondes radio selon la revendication 1,
dans lequel l'absorbeur d'ondes radio présente un rapport de rectitude compris entre 0,45 et 0,55.

3. Absorbeur d'ondes radio selon la revendication 1 ou 2,
dans lequel la ferrite hexagonale présente une composition représentée par Formule 1,
Formule 1 AFE₍₁₂₋ₓ₎AlₓO₁₉
dans formule (1), A représente au moins un type d'atome choisi parmi le groupe constitué de Sr, Ba, Ca et Pb, et x satisfait 1,50 ≤ x ≤ 8,00.

4. Absorbeur d'ondes radio selon la revendication 3,
dans lequel un atome représenté par A dans Formule 1 inclut Sr.

5. Absorbeur d'ondes radio selon l'une quelconque des revendications 1 à 4,
dans lequel l'absorbeur d'ondes radio est un produit moulé obtenu en moulant une composition contenant la poudre d'une ferrite hexagonale et le liant.

6. Absorbeur d'ondes radio selon la revendication 5,
dans lequel l'absorbeur d'ondes radio est un produit moulé en forme de plaque.
